# EUROPEAN PATENT SPECIFICATION

(11) **EP 2 223 534 B1**
(45) Date of publication and mention of the grant of the patent: **18.05.2011**
(21) Application number: 08862615.5
(22) Date of filing: 09.12.2008
(51) Int. Cl.: H04R 19/00, H04R 31/00, H04R 19/01

(54) **MEMS MICROPHONE**
MEMS-MIKROFON
MICROPHONE MEMS

(30) Priority: 17.12.2007 EP 07123378
(43) Date of publication of application: 01.09.2010
(73) Proprietor: NXP B.V., 5656 AG Eindhoven (NL)
(72) Inventor: RENNER, Heinz, A-1102 Vienna (AT)
(74) Representative: Krott, Michel
(86) International application number: PCT/IB2008/055158
(87) International publication number: WO 2009/077917

(56) References cited:
- WO-A-03/047307
- US-A1- 2006 017 125
- US-A1- 2007 189 555

## Description

### FIELD OF THE INTENTION

The invention relates to MEMS microphones.

### BACKGROUND OF THE INVENTION

Prior art microphones are prone to the influence by sound which is transferred via solid connection, which is not induced by air pressure but is induced by movements of the body of the microphone or the body the microphone (body noise) is fixed to. This movement generates a noise signal in the microphone not relating to sound or voice, which is to be recorded by the microphone, therefore leading to a degrading of the performance of the microphone.

WO2003/047307 describes a miniature condenser microphone and the fabrication thereof. An acoustic pressure type sensor is described as being imbricated on a supporting substrate, The acoustic sensor is fabricated by depositing and etching a number of thin films on the supporting substrate and machining the supporting substrate. The resulting structure contains a pressure sensitive, electrically conductive diaphragm positioned at s distance from an electrical conductive fixed electrode. In operation, the diaphragm defects in response to an acoustic pressure and the corresponding change of electrical capacitance between the diaphragm and the fixed electrode is detected using an electrical circuit.

### SUMMARY OF THE INVENTION

The invention is defined in the accompanying claims.

An embodiment of the invention can provide a microphone having a low level of susceptibility to body noise.

According to an aspect of the invention, a Micro-Electro-Mechanical System (MEMS) microphone is provided, wherein the MEMS microphone comprises a membrane attached to a substrate and an electrode attached to the substrate, wherein the membrane and the electrode have the same resonant frequency.

In this application the term "attached to a substrate" may particularly denote the fact that the part, e.g. the membrane or the electrode, may be attached to or even may be formed as a part of the substrate, i.e. are fixedly connected to the substrate. In particular, the term may also include that the substrate and the membrane or electrode may be fixed:to each other by a connection element or that the membrane and/or electrode forms an integrally part of the substrate. Furthermore, the term may also include an arrangement wherein the membrane is fixed or attached directly to the electrode, which in turn is fixed oar attached to the substrate. In this arrangement the electrode may comprise a stiff outer region, e.g. an annular outer region in case of a circular membrane and electrode, having elastic strips or elastic bands implemented so that an oscillation of the membrane and electrode is possible. These elastic strips may be arranged in radial direction of the electrode.

Furthermore, in this application the term "MEMS" or "Micro-Electro-Mechanical System" may particularly denote the technology of the and merges at the nanoscale into nanoelectromechanical systems (NEMS) and nanotechnology. MEMS may also be referred to as micro-machines, or *Micro Systems Technology* (*MST*), MEMS may be separate and distinct from the hypothetical vision of molecular nanotechnology or molecular electronics MEMS generally ranges in size from a micrometer to a millimeter. Thus, a MEMS microphone may denote a microphone having a size in the above-described range, i.e. in the range from micrometer to some millimeters.

By providing a MEMS microphone, whose electrode and membrane have the same resonant frequency, a new type of microphone ifs provided, i.e. a small microphone, which is still not object to body noise, i.e. is not be influenced by movements of a body the microphone is fixed to (e.g. by fixing or mounting the electrode to said body). The so-called body noise is particularly induced by body movements and not by variations in air pressure. By ensuring that the membrane and the electrode have the same resonant frequency it is possible to ensure that the membrane and the electrode are moving parallel or synchronous when the MEMS microphone is moved. In other words, it is possible to avoid a relative movement between the membrane and the electrode, which relative movement otherwise would cause an output signal (e.g. to an amplifier and a downstream speaker) and thus decrease the performance of the microphone.

It should be noted that due to the small size of MEMS microphones compared to standard microphones the resonant frequencies of the MEMS components are much higher, e.g. in the range of about, 100 kHz. Thus, emphasis should be put on the matching of the resonance frequencies for a proper performance of the microphone while the resonance quality is less important than for normal microphones.

An embodiment of the invention can provide a MEMS microphone having a reduced susceptibility to movements performed by a body the MEMS microphone is fixed to, by ensuring that a membrane and an electrode of the MEMS microphone have the same or almost the same resonant frequency. Thus, it is ensured that the membrane and the electrode move synchronous when the microphone is moved so that no relative movement between the electrode and membrane is induced, which relative movement may lead to an additional unintended signal.

Next, further embodiments of the MEMS microphone are described.

According to an embodiment of the MEMS microphone, the electrode is formed as a back-electrode. Furthermore, the MEMS microphone may be a capacity type MEMS microphone. In particular, the MEMS microphone may be a microphone that is based on a detection mechanisms of the group of detection mechanisms consisting of: optical detection mechanism, electret mechanism, electromechanic mechanism, and electrodynamic mechanism.

According to another embodiment, the MEMS microphone further comprises an elastic suspension, which is arranged between the electrode and the substrate. In particular, the elastic suspension may comprise a material having a lower Young modulus than the Young modulus of the electrode and/or the substrate. For example, the elastic suspension may be formed or may consist of the material. The provision of an elastic suspension, i.e. an elastic fixation, between the electrode and the substrate or frame may be a suitable way to ensure that the fixation of the electrode to the microphone substrate or microphone frame is realized in a way that the stiffness of the elastic suspension together with the mass of the electrode possibly results into the same fundamental resonance frequency as the resonance frequency of the microphone membrane itself. Thus, it may be possible to ensure that no relative movement between the membrane and the electrode is induced when body movements are applied to the microphone while sound pressure may not induce a significant movement of the electrode due to the relative high mass of the electrode compared to the membrane.

According to yet another embodiment of the MEMS microphone, the elastic suspension is adapted in such a way that the membrane and the electrode have the same resonant frequency. In particular, the elastic suspension may have a spring constant, which is adapted in such a way that the resonant frequency of the membrane and the electrode are the same. The spring constant of the suspension depends on the shape of the suspension and the material of the suspension. Thus, the spring constant may be set by choosing an appropriate form (dimension) and/or an appropriate material for the suspension.

According to another embodiment of the microphone, the suspension and/or the electrode and/or the substrate comprises the same material. In particular, the suspension and or the electrode and/or the substrate may be formed of or may consist of the same material. In this respect the term "attached to" just relates to functional entities and does neither mean the parts of the microphone consist of different materials nor that separate parts of a microphone are connected to one another. By contrast, these functional entities can be formed of one ""block" of material, e.g. by etching.

According to another embodiment of the MEMS microphone, the membrane and the electrode comprise the same material. In particular, the membrane and the electrode may be formed of or may consist of the same material.

According to another embodiment of the MEMS microphone, the membrane and/or the electrode comprises silicone. In particular, the membrane and/or the electrode may be formed or may be consist of silicone.

Summarizing, according to an aspect of the invention, a MEMS microphone of a capacity type is provided having a membrane and a fixed back-electrode. The MEMS microphone may be adapted for body noise compensation, which is induced by body movement and transmitted to the microphone via different movements of the membrane and the back electrode. The compensation is achieved by ensuring that a resonant frequency of the membrane and the back-electrode have the same value so that the body and thus of the back-electrode move in parallel and not relative to each other.

The aspects and embodiments defined above and further aspects of the invention are apparent from the example of embodiment to be described hereinafter and are explained with reference to this example of embodiment. It should be noted that features described in connection with one exemplary embodiment or exemplary aspect may be combined with other exemplary embodiments and other exemplary aspects.

### BRIEF DESCRIPTION OF THE DRAWINGS

The invention will be described in more detail hereinafter with reference to an example of embodiment but to which the invention is not limited.

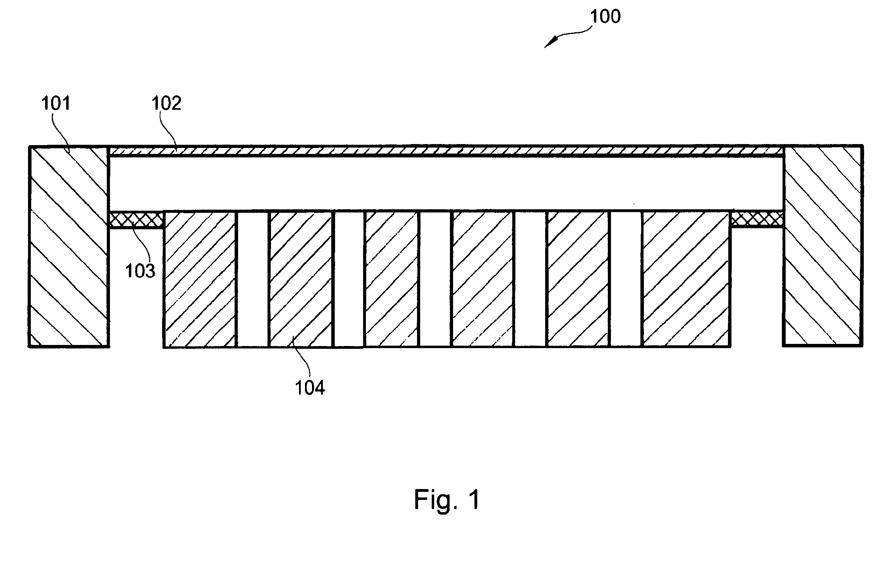

Fig. 1 schematically illustrates a MEMS microphone according to an exemplary embodiment of the invention.

### DESCRIPTION OF EMBODIMENTS

Fig. 1 schematically shows a MEMS microphone 10 comprising a microphone frame or substrate 101, which a membrane 102 is fixed to, and an elastic suspension 103, which is fixed to the microphone frame 101 as well as to a back-electrode 104, The membrane 102 and/or the back-electrode 104 may comprise or may consist of silicone and may have a circular shape. However, any other shape is applicable as well, e.g. rectangular with or without rounded corners, elliptical, etc. The back-electrode 104 comprises holes so that air can pass it, either for exposing the membrane 102 to sound or ventilating the small back volume between membrane 102 and back-electrode 104. In particular, the elastic suspension 103 comprises or consists of a material having a lower Young modulus than the Young modulus of the electrode 104 and/or the substrate 101. The provision of an elastic suspension 103, i.e. an elastic fixation, between the electrode 104 and the substrate or frame 101 may be a suitable way to ensure that the stiffness of the elastic suspension 103 together with the mass of the electrode 104 results in the same fundamental resonance frequency as the resonance frequency of the microphone membrane 102 itself.

However, the elasticity of the suspension 103 is not just defined by the properties of the material the suspension consists of but also by its shape. The shape of the suspension 103 and the material, which the suspension 103 consists of, define the spring constant of the suspension 103. Said spring constant and the mass of the electrode 104 define a mass spring system with characteristic oscillation properties.

Finally, it should be noted that the above-mentioned embodiments illustrate rather than limit the invention, and that those skilled in the art will be capable of designing many alternative embodiments without departing from the scope of the invention as defined by the appended claims. In the claims, any reference signs placed in parentheses shall not be construed as limiting the claims. The word "comprise" and its conjugations do not exclude the presence of elements or steps other than those listed in any claim or the specification as a whole. The singular reference of an element does not exclude the plural reference of such elements and vice-versa. In a device claim enumerating several means, several of these means may be embodied by one and the same item. The mere fact that certain measures are recited in mutually different dependent claims does not indicate that a combination of these measures cannot be used to advantage.

## Claims

1. A MEMS microphone (100) comprising:
a substrate (101),
a membrane (102) attached to the substrate (101), and
an electrode (104) attached to the substrate (101),
wherein the membrane (102) and the electrode (104) have the same resonance frequency.

2. The MEMS microphone (100) according to claim 1, wherein the electrode (104) is formed as a back-electrode.

3. The MEMS microphone (100) according to claim 1, wherein the MEMS microphone (100) is a capacity type MEMS microphone.

4. The MEMS microphone (100) according to claim 1, further comprising an elastic suspension (103) arranged between the electrode (104) and the substrate (101).

5. The MEMS microphone (100) according to claim 4, wherein the elastic suspension (103) comprises a material having a lower Young modulus than the Young modulus of the electrode and/or the substrate.

6. The MEMS microphone (100) according to claim 4, wherein the elastic suspension (103) is adapted in such a way that the membrane (102) and the electrode (104) have the same resonant frequency.

7. The MEMS microphone (100) according to claim 4, wherein the elastic suspension (103) and/or the electrode (104) and/or the substrate (101) comprises the same material.

8. The MEMS microphone (100) according to claim 1, wherein the membrane (102) and the electrode (104) comprise the same material.

9. The MEMS microphone (100) according to claim 1, wherein the membrane (102) and/or the electrode (104) comprise silicone.

10. The MEMS microphone (100) according to claim 1, wherein the MEMS microphone (100) is based on one detection mechanism of the group of detection mechanisms consisting of:
optical detection mechanism,
electret mechanism,
electromechanic mechanism, and
electrodynamic mechanism

## Patentansprüche

1. Ein MEMS Mikrophon (100) aufweisend:
ein Substrat (101),
eine Membran (102), die an dem Substrat (101) befestigt ist, und
eine Elektrode (104), die an dem Substrate (101) befestigt ist,
wobei die Membran (102) und die Elektrode (104) die gleiche Resonanzfrequenz haben.

2. Das MEMS Mikrophon (100) gemäß Anspruch 1, wobei
die Elektrode (104) als eine Rück-Elektrode ausgebildet ist.

3. Das MEMS Mikrophon (100) gemäß Anspruch 1, wobei
das MEMS Mikrophon (100) ein Kapazitätstyp MEMS Mikrophon ist.

4. Das MEMS Mikrophon (100) gemäß Anspruch 1, ferner aufweisend
eine elastische Aufhängung (103), die zwischen der Elektrode (104) und dem Substrat (101) eingerichtet ist.

5. Das MEMS Mikrophon (100) gemäß Anspruch 4, wobei
die elastische Aufhängung (103) ein Material aufweist, welches ein niedrigeres Young Modul hat als das Young Modul der Elektrode und/oder des Substrats.

6. Das MEMS Mikrophon (100) gemäß Anspruch 4, wobei
die elastische Aufhängung (103) derart angepasst ist, dass die Membran (102) und die Elektrode (104) die gleiche Resonanzfrequenz haben.

7. Das MEMS Mikrophon (100) gemäß Anspruch 4, wobei
die elastische Aufhängung (103) und/oder die Elektrode (104) und/oder das Substrat (101) das gleiche Material aufweisen.

8. Das MEMS Mikrophon (100) gemäß Anspruch 1, wobei die Membran (102) und die Elektrode (104) das gleiche Material aufweisen.

9. Das MEMS Mikrophon (100) gemäß Anspruch 1, wobei die Membran (102) und/oder die Elektrode Silikon aufweisen.

10. Das MEMS Mikrophon (100) gemäß Anspruch 1, wobei
das MEMS Mikrophon (100) auf einem Detektionsmechanismus aus der Gruppe der Detektionsmechanismen basiert, die Gruppe bestehend aus:
optischer Detektionsmechanismus,
Elektret Mechanismus,
elektromechanischer Mechanismus, und
elektrodynamischer Mechanismus

## Revendications

1. Microphone MEMS (100) comprenant :
un substrat (101),
une membrane (102) fixée au substrat (101), et
une électrode (104) fixée au substrat (101),
dans lequel la membrane (102) et l'électrode (104) ont la même fréquence de résonance.

2. Microphone MEMS (100) selon la revendication 1, dans lequel l'électrode (104) est formée en tant qu'électrode arrière.

3. Microphone MEMS (100) selon la revendication 1, dans lequel le microphone MEMS (100) est un microphone MEMS de type capacitif.

4. Microphone MEMS (100) selon la revendication 1, comprenant en outre une suspension élastique (103) disposée entre l'électrode (104) et le substrat (101).

5. Microphone MEMS (100) selon la revendication 4, dans lequel la suspension élastique (103) comporte un matériau ayant un module de Young plus faible que le module de Young de l'électrode et/ou du substrat.

6. Microphone MEMS (100) selon la revendication 4, dans lequel la suspension élastique (103) est agencée de telle manière que la membrane (102) et l'électrode (104) ont la même fréquence de résonance.

7. Microphone MEMS (100) selon la revendication 4, dans lequel la suspension élastique (103) et/ou l'électrode (104) et/ou le substrat (101) comprennent le même matériau.

8. Microphone MEMS (100) selon la revendication 1, dans lequel la membrane (102) et l'électrode (104) comprennent le même matériau.

9. Microphone MEMS (100) selon la revendication 1, dans lequel la membrane (102) et/ou l'électrode (104) comprennent du silicone.

10. Microphone MEMS (100) selon la revendication 1, dans lequel le microphone MEMS (100) est fondé sur un mécanisme de détection parmi le groupe de mécanismes de détection constitué des éléments suivants :
mécanisme de détection optique,
mécanisme à électret,
mécanisme électromécanique, et
mécanisme électrodynamique.
